(19) Europäisches Patentamt
European Patent Office
Office européen des brevets

(11) **EP 1 803 835 A1**

(12) **EUROPEAN PATENT APPLICATION**

(43) Date of publication:
**04.07.2007 Bulletin 2007/27**

(21) Application number: **06125509.7**

(22) Date of filing: **06.12.2006**

(51) Int Cl.:
*C23C 16/30* (2006.01)   *C23C 16/34* (2006.01)
*C23C 16/36* (2006.01)   *C23C 16/40* (2006.01)
*C23C 30/00* (2006.01)   *B23P 15/28* (2006.01)

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **30.12.2005 SE 0502959**

(71) Applicant: **Sandvik Intellectual Property AB 811 81 Sandviken (SE)**

(72) Inventor: **Hessman, Ingemar SE-811 54, Sandviken (SE)**

(74) Representative: **Taquist, Henrik Lennart Emanuel Sandvik Intellectual Property AB 811 81 Sandviken (SE)**

(54) **Coated cutting tool insert**

(57)   The present invention discloses a cutting tool insert particularly for deep hole drilling comprising a cemented carbide body and a coating. The cemented carbide body comprises WC, 8-11 wt-% Co and 0.1-0.5 wt-% Cr with an HcJ-value of 18-22 kA/m and with an CW-value of 0.78-0.90. The coating comprises
- a first, innermost layer of $TiC_xN_yO_z$ with x+y+z=1, y>x and z<0.2 with equiaxed grains with size <0.5 $\mu$m and a total thickness of 0.1-1.5 $\mu$m,
- a layer of $TiC_xN_y$ with x+y=1, x>0.3 and y>0.3 with a thickness of 2-3 $\mu$m with columnar grains with an average diameter of <5 $\mu$m,
- a layer of a smooth, fine-grained, 0.5-2 $\mu$m $\kappa$-$Al_2O_3$ with a thickness of 1-2.5 $\mu$m and
- an outer layer of TiN with a thickness of 0.5-1.0 $\mu$m, where the outermost layer of TiN is missing along the cutting edge and preferably the underlying alumina layer is partly or completely missing along the cutting edge.

EP 1 803 835 A1

**Description**

The present invention relates to coated cemented carbide cutting tool inserts for deep hole drilling particularly with tools based on the Ejector® system.

Drilling in metals is generally divided in two types: deep hole drilling and short hole drilling. With short hole drilling is meant generally drilling to a depth of up to 3-5 times the drill diameter.

With short hole drilling the demands are not as great and therefore simple helix drills either of solid cemented carbide or as solid tool steel or of tool steel equipped with cemented carbide inserts are used.

Deep hole drilling however puts large demands on good chipbreaking, lubrication, cooling and not at least chip transport. These requirements are achieved through specially developed drilling systems with specially designed drill heads connected to a drill rod which fulfills the above mentioned requirements. The drilling head may be of solid cemented carbide but is generally of tool steel or cast steel, provided with a number of inserts of cemented carbide placed in such away that they together form the desired cutting edge.

US 5,945,207 discloses a coated cutting insert particularly useful for cutting in cast iron materials. The insert is characterized by a straight WC-Co cemented carbide body having a highly W-alloyed Co binder phase, a well-defined surface content of Co and a coating including an innermost layer of $TiC_xN_yO_z$ with columnar grains, a layer of a fine-grained, textured $Al_2O_3$ and a top layer of $TiC_xNyO_z$ that has been removed along the cutting edge line.

US 6,638,609 discloses coated milling inserts particularly useful for milling of grey cast iron with or without cast skin under wet conditions at low and moderate cutting speeds and milling of nodular cast iron and compacted graphite iron with or without cast skin under wet conditions at moderate cutting speeds. The inserts are characterised by a WC-Co cemented carbide with a low content of cubic carbides and a highly W-alloyed binder phase and a coating including an inner layer of $TiC_xN_y$ with columnar grains followed by a layer of $\kappa$-$Al_2O_3$ and a top layer of TiN.

It is an object of the present invention to provide coated cemented carbide cutting tool inserts, particularly useful for deep hole drilling of drive shafts.

It has now surprisingly been found that an essentially doubled tool life can be obtained for deep hole drilling of drive shafts by using a coated cutting tool insert comprising a cemented carbide body with a relatively high W-alloyed binder phase and with a well balanced chemical composition and grain size of the WC, a columnar $TiC_xN_y$-layer, a $\kappa$-$Al_2O_3$-layer, a TiN-layer and optionally with smoothed cutting edges.

According to the present invention, a coated cutting tool insert is provided of a cemented carbide body with a composition of 8-11 wt-% Co, preferably 9.5-10.5 wt-% Co, most preferably 9.9-10.1 wt-% Co, 0.1-0.5 wt-% Cr, preferably 0.38-0.40 wt-% Cr and balance WC. The cemented carbide body may also contain smaller amounts of other elements on a level corresponding to a technical impurity. The polarization coercivity, HcJ, measured according to IEC standard 60404-7, is indirectly a measure of the WC grain size and should have a value of 18-22 kA/m, preferably 19-21 kA/m, most preferably 19.8-20.2 kA/m. The cobalt binder phase is alloyed with a certain amount of W and Cr giving the invented cemented carbide cutting insert its desired properties. W and Cr in the binder phase influence the magnetic properties of cobalt and can hence be related to a value CW, defined as

$$CW= magnetic -\% \ Co \ / \ wt-\%Co$$

where magnetic -% Co is the weight percentage of magnetic material in the sample and wt-%Co is the weight percentage of Co in the sample.

The CW-value is dependent on the degree of alloying of the binder phase. Lower CW-values correspond to higher W and Cr contents and CW=1 corresponds practically to an absence of W and Cr in the binder phase.

The CW-value can vary between 1 and about 0.75 dependent on the degree of alloying. Lower CW-values correspond to higher W and Cr contents and CW=1 corresponds practically to an absence of W and Cr in the binder phase.

It has now been found according to the present invention that improved cutting performance is achieved if the cemented carbide body has a CW-value of 0.78-0.90, preferably within 0.80-0.89, and most preferably within 0.83-0.87. The cemented carbide may also contain small amounts, <1 volume %, of $\eta$-phase ($M_6C$), without any detrimental effects. From the specified CW-values (< 1) it also follows that no free graphite is allowed in the cemented carbide body according to the present invention.

The radius of the uncoated cutting edge is 5-30 $\mu$m, preferably about 10-20 $\mu$m.

The coating comprises

- a first (innermost) layer of $TiC_xNyO_z$ with x+y+z=1, y>x and z<0.2, preferably y>0.8 and z=0, with equiaxed grains with size <0.5 $\mu$m and a total thickness <1.5 $\mu$m preferably >0.1 $\mu$m,
- a layer of $TiC_xN_y$ with x+y=1, x>0.3 and y>0.3, preferably x$\geq$0.5, with a thickness of 2-3 $\mu$m with columnar grains

and with an average diameter of <5 $\mu$m, preferably 0.1-2 $\mu$m,

- a layer of a smooth, fine-grained (average grain size about 0.5-2 $\mu$m) $Al_2O_3$ consisting essentially of the $\kappa$-phase. However, the layer may contain small amounts (<5 vol-%) of other phases such as $\theta$- or the $\alpha$-phase as determined by XRD-measurement. The $Al_2O_3$-layer has a thickness of 1-2 $\mu$m, preferably 1.2-1.7 $\mu$m and
- a further 0.1-1.0 $\mu$m thick layer of TiN. This outermost layer of TiN has a surface roughness $R_{max} \leq 0.4$ $\mu$m over a length of 10 $\mu$m at least on the active part of the cutting edge. The TiN-layer is preferably removed along the cutting edge and the underlying alumina layer may be partly or completely removed along the cutting edge.

The present invention also relates to a method of making a cutting tool insert particularly for deep hole drilling comprising a cemented carbide body and a coating. The cemented carbide body comprises WC, 8-11 wt-% Co, more preferably 9.5-10.5 wt-% Co, most preferably 9.9-10.1 wt-% Co and 0.1-0.5 wt-% Cr, more preferably 0.38-0.40 wt-% Cr with HcJ of 18-22 kA/m, more preferably 19-21 kA/m, most preferably 19.8-20.2 kA/m and with a CW-value within 0.78-0.90, preferably within 0.80-0.89, and most preferably within 0.83-0.87.

The uncoated cutting edge is provided with an edge radius of 5-30 $\mu$m, preferably about 10-20 $\mu$m.

The coating comprises:

- a first (innermost) layer of $TiC_xN_yO_z$ with x+y+z=1, y>x and z<0.2, preferably y>0.8 and z=0, with equiaxed grains with size <0.5 $\mu$m and a total thickness <1.5 $\mu$m, preferably >0.1 $\mu$m, using known CVD-methods,
- a layer of $TiC_xN_y$ with x+y=1, x>0.3 and y>0.3, preferably x$\geq$0.5, with a thickness of 1-3 $\mu$m, preferably 2-2.7 $\mu$m, with columnar grains and with an average diameter of <5 $\mu$m, preferably 0.1-2 $\mu$m using preferably MTCVD-technique (using acetonitrile as the carbon and nitrogen source for forming the layer in the temperature range of 700-900°C). The exact conditions, however, depend to a certain extent on the design of the equipment used,
- a smooth $Al_2O_3$-layer essentially consisting of $\kappa$-$Al_2O_3$ is deposited under conditions disclosed in e.g. US 5,674,564. The $Al_2O_3$ layer has a thickness of 0.5-2.5 $\mu$m, preferably 1-2 $\mu$m and
- a 0.5-1.0 $\mu$m thick layer of TiN with a surface roughness $R_{max} \leq 0.4$ $\mu$m over a length of 10 $\mu$m at least on the active part of the cutting edge.

The smooth coating surface is obtained by gently wetblasting the coating surface with fine grained (400-150 mesh) alumina powder or by brushing the edges with brushes based on e.g. SiC as disclosed e.g. in US 5,861,210. The TiN-layer is preferably removed along the cutting edge and the underlying alumina layer may be partly or completely removed along the cutting edge.

The invention also relates to the use of cutting tool inserts according to above for deep hole drilling of drive shafts in steel at a cutting speed of 80-160 m/min, feed of 0.1-0.3 mm/rev, hole diameter of 16-65 mm and a hole length of <1500 mm.

The invention is additionally illustrated in connection with the following examples, which are to be considered as illustrative of the present invention. It should be understood, however, that the invention is not limited to the specific details of the

examples.

Example 1

Cemented carbide inserts with a composition of 10 wt-% Co, 0.4 wt-% Cr and balance WC, and with an HcJ value of 20.2 kA/m and an CW-value of 0.85 as measured in the FÖRSTER KOERZIMAT CS 1.096 from Foerster Instruments Inc were after conventional ER-treatment to an edge radius of 15 $\mu$m coated with a 0.5 $\mu$m equiaxed $TiC_{0.05}N_{0.95}$-layer (with a high nitrogen content corresponding to an estimated C/N-ratio of 0.05) followed by a 2.6 $\mu$m thick $TiC_{0.54}N_{0.46}$-layer, with columnar grains by using MTCVD-technique (temperature 850-885°C and $CH_3CN$ as the carbon/nitrogen source). In subsequent steps during the same coating cycle, a 1.3 $\mu$m thick layer of $Al_2O_3$ was deposited using a temperature 970°C and a concentration of $H_2S$ dopant of 0.4 % as disclosed in US 5,674,564. A thin (0.5 $\mu$m) layer of TiN was deposited on top according to known CVD-technique. XRD-measurement showed that the $Al_2O_3$-layer consisted of 100% $\kappa$-phase.

The coated inserts were brushed using a nylon straw brush containing SiC grains. Examination of the brushed inserts in a light optical microscope revealed that the outermost, thin TiN-layer and some of the $Al_2O_3$-layer had been brushed away along the very cutting edge, leaving there a smooth $Al_2O_3$-surface. Coating thickness measurements on cross sectioned, brushed inserts showed that the outermost TiN-layer and roughly half the $Al_2O_3$-layer had been removed along the edge line.

Example 2

Inserts according to the present invention were tested in deep hole drilling of shafts in Steel, Ovako 528E.

Tool:            Sandvik Coromant ejector drill 800.20-03D
Criterion:       Flank wear, surface finish.
Reference:       Sandvik Coromant ejector drill 800.20-03D with insert 800-060308H-P-G in grade GC1025.

Cutting data

Cutting speed:        Vc = 112 m/min

Feed per rev:         fn= 0.22 mm

Hole diameter:        25.5 mm

Length of hole:       1160 mm

Coolant:              Emulsion

Tool life of reference:    15 shafts.

Tool life of invention:    35 shafts.

Average of four tests.
The tool according to the invention showed a reduction in flank wear with improved surface finish and an increase in tool life with 133 %.

Example 3

Inserts according to the present invention were tested in deep hole drilling of shafts in Steel, Ovako 528E
Tool: Sandvik Coromant ejector drill 800.20-03D
Criterion: Flank wear, surface finish.
Reference: Sandvik Coromant ejector drill 800.20-03D with insert 800-060308H-P-G in grade GC4025

Cutting data

Cutting speed:        Vc = 137 m/min

Feed per rev:         fn= 0.26 mm

Hole dia.:            25.5 mm

Lenth of hole:        1160 mm

Coolant:              Emulsion

Tool life of reference:    13 shafts.

Tool life of invention:    35 shafts.

Average of four tests.
The tools according to the invention showed a reduction in flank wear with improved surface finish and an increase in tool life with 169 %.

Although the present invention has been described in connection with preferred embodiments thereof, it will be appreciated by those skilled in the art that additions, deletions, modifications, and substitutions not specifically described may be made without department from the spirit and scope of the invention as defined in the appended claims.

## Claims

1. A cutting tool insert comprising a cemented carbide body and a coating **characterized in that** said cemented carbide body comprises WC, 8-11 wt-% Co, more preferably 9.5-10.5 wt-% Co, most preferably 9.9-10.1 wt-% Co and 0.1-0.5 wt-% Cr, more preferably 0.38-0.40 wt-% Cr with a polarization coercivity, HcJ, of 18-22 kA/m, more preferably 19-21 kA/m, most preferably 19.8-20.2 kA/m and with a CW-value within 0.78-0.90, preferably within 0.80-0.89, and most preferably within 0.83-0.87
and **in that** said coating comprises

    - a first, innermost layer of $TiC_xN_yO_z$ with x+y+z=1, y>x and z<0.2, preferably y>0.8 and z=0, with equiaxed grains with size <0.5 $\mu$m and a total thickness of 0.1-1.5 $\mu$m,
    - a layer of $TiC_xN_y$ with x+y=l, x>0.3 and y>0.3, preferably x>0.5, with a thickness of 2-3 $\mu$m with columnar grains with an average diameter of <5 $\mu$m,
    - a layer of a smooth, fine-grained, 0.5-2 $\mu$m $\kappa$-$Al_2O_3$ with a thickness of 1-2.5 $\mu$m and
    - an outermost layer of TiN with a thickness of 0.5-1.0 $\mu$m,
    where the outermost layer of TiN is missing along the cutting edge and preferably the underlying alumina layer is partly or completely missing along the cutting edge.

2. Cutting tool insert according to claim 1 **characterized in the** outermost layer of TiN has a surface roughness $R_{max} \le 0.4$ $\mu$m over a length of 10 $\mu$m at least on the active part of the cutting edge.

3. Method of making a cutting tool insert comprising a cemented carbide body and a coating **characterized in that** said cemented carbide body comprises WC, 8-11 wt-% Co, more preferably 9.5-10.5 wt-% Co, most preferably 9.9-10.1 wt-% Co and 0.1-0.5 wt-% Cr, more preferably 0.38-0.40 wt-% Cr with a polarization coercivity, HcJ, of 18-22 kA/m, more preferably 19-21 kA/m, most preferably 19.8-20.2 kA/m and with an CW-value within 0.78-0.90, preferably within 0.80-0.89, and most preferably within 0.83-0.87
is coated with a coating comprising

    - a first innermost layer of $TiC_xNyO_z$ with x+y+z=1, y>x and z<0.2, preferably y>0.8 and z=0, with equiaxed grains with size <0.5 $\mu$m and a total thickness of 0.1-1.5 $\mu$m, using known CVD-methods,
    - a layer of $TiC_xN_y$ with x+y=1, x>0.3 and y>0.3, preferably x>0.5, with a thickness of 2-3 $\mu$m, with columnar grains and with an average diameter of <5 $\mu$m, preferably 0.1-2 $\mu$m using preferably MTCVD-technique with acetonitrile as the carbon and nitrogen source for forming the layer in the temperature range of 700-900°C,
    - a smooth $Al_2O_3$-layer essentially consisting of $\kappa$-$Al_2O_3$ is deposited using known CVD-methods whereby the $Al_2O_3$ layer has a thickness of 1-2.5 $\mu$m, and
    - a further 0.5-1.0 $\mu$m thick layer of TiN using known CVD- or PVD-methods, where the TiN-layer is removed along the cutting edge and preferably removing the underlying alumina layer partly or completely along the cutting edge.

4. Method according to claim 3 **characterized in** gently wetblasting the coating surface with fine grained, 400-150 mesh, alumina powder or by brushing the edges with brushes based on e.g. SiC to obtain a surface roughness of $R_{max} \le 0.4$ $\mu$m over a length of 10 $\mu$m at least on the active part of the cutting edge.

5. Use of inserts according to claims 1-2 for deep hole drilling of drive shafts for heat exchangers in steel at a cutting speed of 80-160 m/min, feed of 0.1-0.3 mm/rev, hole diameter of 16-65 mm and a hole length of <1500 mm.

**European Patent Office**

## EUROPEAN SEARCH REPORT

Application Number

EP 06 12 5509

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 97/20082 A (SANDVIK AB [SE]; LINDSKOG PER [SE]; GUSTAFSON PER [SE]; LJUNGBERG BJOE) 5 June 1997 (1997-06-05) * page 2, line 27 - page 5, line 26 * ----- | 1-4 | INV. C23C16/30 C23C16/34 C23C16/36 C23C16/40 C23C30/00 B23P15/28 |
| Y | EP 1 038 989 A2 (SANDVIK AB [SE]) 27 September 2000 (2000-09-27) * paragraph [0010]; examples 1-3 * ----- | 1-5 | |
| Y | US 2004/067115 A1 (YAMAMOTO TAKAHIRO [JP]) 8 April 2004 (2004-04-08) * paragraphs [0041], [0042] * ----- | 5 | |
| A | FANG Z Z: "Correlation of transverse rupture strength of WC-Co with hardness" INTERNATIONAL JOURNAL OF REFRACTORY METALS AND HARD MATERIALS, ELSEVIER PUBLISHERS, BARKING, GB, vol. 23, no. 2, March 2005 (2005-03), pages 119-127, XP004765753 ISSN: 0263-4368 * table 1 * ----- | 1-4 | |
| A | ROEBUCK B: "Terminology, testing, properties, imaging and models for fine grained hardmetals" INTERNATIONAL JOURNAL OF REFRACTORY & HARD METALS UK, vol. 13, no. 5, 1995, pages 265-279, XP002427700 ISSN: 0263-4368 * abstract * ----- | 1-4 | TECHNICAL FIELDS SEARCHED (IPC)  C23C B23P |
| A | WO 2004/056513 A (GÜHRING JÖRG [DE]; KAROS HORST [DE]) 8 July 2004 (2004-07-08) * page 13, lines 26-34 * * page 17, line 34 - page 18, line 12 * * page 30, line 28 - page 31, line 2 * ----- | 5 | |

The present search report has been drawn up for all claims

| Place of search | Date of completion of the search | Examiner |
|---|---|---|
| Munich | 2 April 2007 | Hoyer, Wolfgang |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 12 5509

This annex lists the patent family members relating to the patent documents cited in the above-mentioned European search report.
The members are as contained in the European Patent Office EDP file on
The European Patent Office is in no way liable for these particulars which are merely given for the purpose of information.

02-04-2007

| Patent document cited in search report | | Publication date | Patent family member(s) | | Publication date |
|---|---|---|---|---|---|
| WO 9720082 | A | 05-06-1997 | AT | 213283 T | 15-02-2002 |
| | | | BR | 9611781 A | 23-02-1999 |
| | | | CN | 1203637 A | 30-12-1998 |
| | | | DE | 69619275 D1 | 21-03-2002 |
| | | | DE | 69619275 T2 | 24-06-2004 |
| | | | EP | 0874919 A1 | 04-11-1998 |
| | | | IL | 124475 A | 26-08-2001 |
| | | | JP | 2000515588 T | 21-11-2000 |
| | | | US | 6200671 B1 | 13-03-2001 |
| EP 1038989 | A2 | 27-09-2000 | AT | 269429 T | 15-07-2004 |
| | | | DE | 60011494 D1 | 22-07-2004 |
| | | | DE | 60011494 T2 | 28-10-2004 |
| | | | JP | 2000308916 A | 07-11-2000 |
| | | | SE | 519005 C2 | 17-12-2002 |
| | | | SE | 9901149 A | 27-09-2000 |
| | | | US | 6250855 B1 | 26-06-2001 |
| US 2004067115 | A1 | 08-04-2004 | DE | 10331328 A1 | 15-04-2004 |
| | | | JP | 3720010 B2 | 24-11-2005 |
| | | | JP | 2004122288 A | 22-04-2004 |
| | | | KR | 20040030231 A | 09-04-2004 |
| | | | US | 2006275092 A1 | 07-12-2006 |
| WO 2004056513 | A | 08-07-2004 | AU | 2003299278 A1 | 14-07-2004 |
| | | | DE | 10394165 D2 | 03-11-2005 |
| | | | EP | 1572402 A2 | 14-09-2005 |
| | | | JP | 2006510804 T | 30-03-2006 |
| | | | KR | 20050085843 A | 29-08-2005 |
| | | | US | 2006006576 A1 | 12-01-2006 |

EPO FORM P0459

For more details about this annex : see Official Journal of the European Patent Office, No. 12/82

**EP 1 803 835 A1**

**REFERENCES CITED IN THE DESCRIPTION**

**Patent documents cited in the description**

- US 5945207 A
- US 6638609 B
- US 5674564 A
- US 5861210 A